**Europäisches Patentamt**

**European Patent Office** (11) Publication number: **0 053 075**

**Office européen des brevets** **B1**

(12) **EUROPEAN PATENT SPECIFICATION**

(45) Date of publication of patent specification: **20.04.88** (51) Int. Cl.⁴: **G 11 C 17/00**

(21) Application number: **81401837.0**

(22) Date of filing: **20.11.81**

(54) Nonvolatile memory.

(30) Priority: **26.11.80 JP 166355/80**
**26.11.80 JP 166354/80**

(43) Date of publication of application:
**02.06.82 Bulletin 82/22**

(45) Publication of the grant of the patent:
**20.04.88 Bulletin 88/16**

(84) Designated Contracting States:
**DE FR GB NL**

(56) References cited:
**GB-A-2 005 915**
**US-A-4 099 196**
**US-A-4 165 538**
**US-A-4 203 158**

(73) Proprietor: **FUJITSU LIMITED**
**1015, Kamikodanaka Nakahara-ku**
**Kawasaki-shi Kanagawa 211 (JP)**

(72) Inventor: **Hideki, Arakawa**
**13-17, Umegaoka Midori-ku**
**Yokohama-shi Kanagawa 227 (JP)**
Inventor: **Mitsuo, Higuchi**
**2-5-13, Yutenji**
**Meguro-ku Tokyo 153 (JP)**

(74) Representative: **Descourtieux, Philippe et al**
**CABINET BEAU de LOMENIE 55 rue**
**d'Amsterdam**
**F-75008 Paris (FR)**

Courier Press, Leamington Spa, England.

## Description

The present invention relates to a nonvolatile memory, and more particularly relates to a nonvolatile semiconductor EE-PROM (Electrically Erasable-Programmable Read-Only Memory) of the type comprising a plurality of memory cells and a plurality of column lines and program lines which cooperate with the memory cells, each memory cell comprising a selecting transistor and a programming transistor connected in series with the selecting transistor and comprised of a read transistor having a control gate and a floating gate provided with a relatively thick insulation layer thereunder, and a write-erase transistor having a control gate and a floating gate provided with, partially, a relatively thin insulation layer thereunder, the control gates being commonly connected and the floating gates being also commonly connected, the selecting transistor having a drain connected to the column line and a gate connected to the row line, and the read and write-erase transistors having their control gates connected to the program lines. A nonvolatile semiconductor EE-PROM of this type is disclosed for example by US—4,203,158.

Programmable ROMs are widely utilized in, for example, computer-aided data processing systems. Usually, a ROM can be programmed only once, either at the factory or in the field, by electrically fusing or otherwise removing unwanted internal links. Accordingly, the conventional programmable ROM has a defect in that a mistake in the programming cannot be corrected. For the purpose of overcoming this defect, an EPROM (Erasable Programmable ROM) has been proposed and widely utilized. In an EPROM, the stored data can be erased by ultraviolet with appropriate voltage pulses. However, in a conventional EPROM, since ultraviolet light is required for reprogramming the stored data, it is not easy for an operator to freely reprogram the stored data.

In recent years, a nonvolatile EE-PROM has been proposed, for example, in the publication "Electronics", February 28, 1980 pages 113 through 117, entitled "16-K EE-PROM relies on tunneling for byte-erasable program storage". The EE-PROM is basically comprised of a transistor having a source, a drain, a floating gate and a control gate, in which the floating gate partially includes an area of a very thin insulation layer on the order of a hundred Å. Thus, a tunnel effect can be created, via the thin insulation, between the drain and the floating gate, and thereby data, to be stored in each memory cell, is reprogrammed.

EE-PROMs are very useful for an operator in, for example, computer-aided data processing systems, because, as previously mentioned, he can freely reprogram the stored data can be freely reprogrammed without using ultraviolet light. However, such an EE-PROM circuit of the prior art has the following two defects. Firstly, undesired erasure of data often occurs in some of the half-selected memory cells, as it will be explained in detail hereinafter. Secondly, mass-production of such EE-PROM circuit devices is not relatively easy.

Therefore, it is an object of the present invention, to provide a nonvolatile memory which can overcome the above-mentioned two defects.

This object is attained with a nonvolatile memory device as defined at the beginning of this description and wherein, according to the invention, in each of the memory cells the selecting transistor is divided into a first selecting transistor and a second selecting transistor, the first selecting transistor being serially connected with the read transistor and the second selecting transistor being serially connected with the write-erase transistor, and wherein the program lines are arranged substantially in parallel with the column lines in the form of lines intersecting the row lines.

The present invention will be more apparent from the ensuing description with reference to the accompanying drawings wherein:

Figure 1 illustrates a cross-sectional view showing a known EE-PROM of a prior art;

Figure 2 depicts a circuit diagram of a conventional memory cell including the transistor of Figure 1 therein;

Figure 3 depicts a circuit diagram of a conventional memory comprised of memory cells MC shown in Figure 2;

Figure 4A depicts an equivalent circuit diagram of each memory cell MC according to the present invention;

Figure 4B depicts an equivalent circuit diagram of each memory cell LC of the prior art;

Figure 5 illustrates a plan view of a memory cell having the circuit diagram of Figure 4A, according to the present invention;

Figure 6 is a cross-sectional view of the memory cell shown in Figure 5 taken along the line 6—6;

Figure 7 is a cross-sectional view of the memory cell shown in Figure 5 taken along the line 7—7;

Figure 8 is a cross-sectional view of the memory cell shown in Figure 5 taken along the line 8—8;

Figure 9 is a cross-sectional view of the memory cell shown in Figure 5 taken along the line 9—9;

Figure 10 illustrates a memory circuit diagram comprised of many memory cells according to the present invention shown in Figures 5 through 9;

Figure 11 illustrates a plan view showing another embodiment of the memory cell according to the present invention; and,

Figure 12 illustrates a memory circuit diagram comprised of many memory cells according to said another embodiment of the present invention.

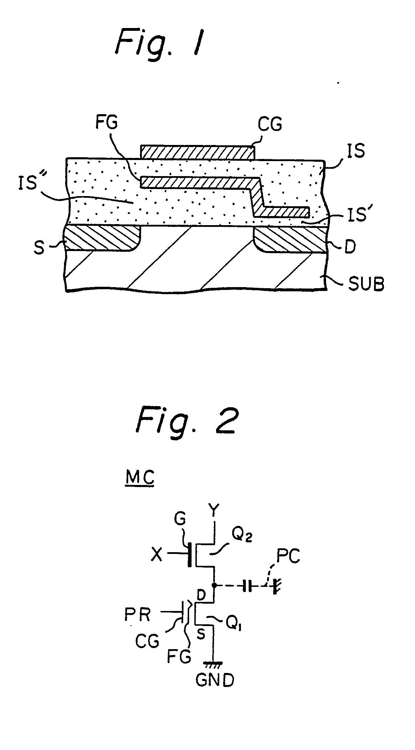

Figure 1 illustrates a cross-sectional view showing a known EE-PROM of a prior art. In Figure 1, a basic transistor, especially, a FET (Field Effect Transistor) of the EE-PROM is formed in and on a semiconductor substrate SUB. A source S and a drain D of the transistor are formed therein. On the substrate SUB, a floating gate FG and a control gate CG are formed via an insulation layer (SiO₂) IS. The floating gate FG partially faces the substrate, especially the drain D, via a very thin insulation layer IS'. The floating gate FG, cooperating with the thin insulation layer IS', is necessary to construct the electrically erasable (EE) memory. When a positive high voltage is applied to the control gate CG, the voltage level of the floating gate FG is also increased by the positive high voltage, due to the presence of a capacitor formed between the gate CG and the gate FG having a relatively thick insulation layer IS''. At this time, if the voltage level, to be applied to the drain D, is set at 0 V, an extremely high electric field is created, across the thin insulation layer IS', between the gate FG and the drain D. Then electron charges are injected from the drain D into the floating gate FG, which phenomena provide a tunnel effect. Thereby an erase operation is completed. Contrary to the above, in a write operation, the voltage level of the control gate CG is set at 0 V and the voltage level of the drain D is set at a positive high voltage, and thus the electron charges are injected from the floating gate FG into the drain D.

Figure 2 depicts a circuit diagram of a conventional memory cell including the transistor of Figure 1 therein. The memory cell MC of Figure 2 is fabricated as a two-transistor cell type memory cell. The memory cell MC is comprised of a programming transistor $Q_1$ which corresponds to the transistor of Figure 1 and a selecting transistor $Q_2$. The symbols D, S, FG and CG denote respectively the aforesaid drain, source, floating gate and control gate. The selecting transistor $Q_2$ is used for accessing the transistor $Q_1$ when this memory cell MC is specified by an address signal. The programming transistor $Q_1$ functions to store, read and write data alternately. These transistors $Q_1$ and $Q_2$ are connected in series with each other along a column line Y, namely a bit line, and to a ground GND. The gate G of the transistor $Q_2$ is connected to a row line X, namely a word line. The control gate CG of the transistor $Q_1$ is connected to a program line PR which is arranged in parallel with the row line X.

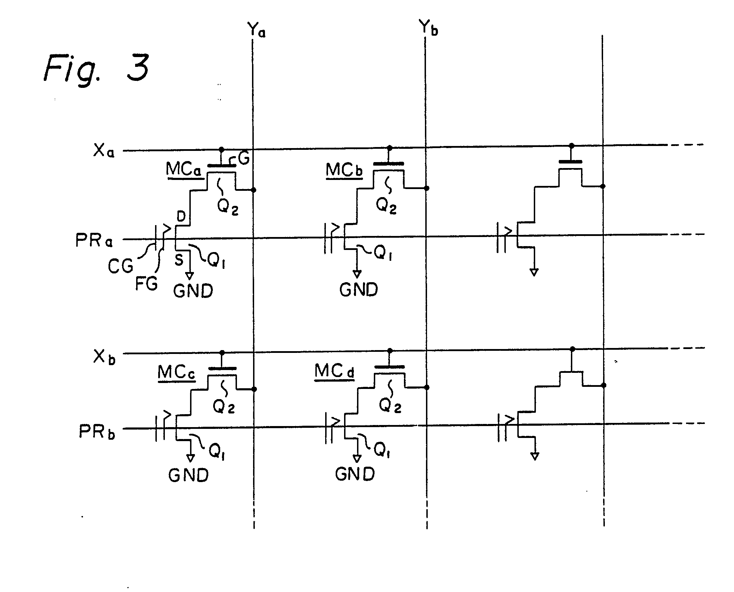

Figure 3 depicts a circuit diagram of a conventional memory comprised of memory cells MC shown in Figure 2. In Figure 3, the members having identical reference symbols are substantially the same as those of Figure 2. In the memory, a write operation is achieved as follows. If the memory cell $MC_a$ is accessed, a positive high voltage, such as +18 V, is applied to the column line $Y_a$ and simultaneously a positive high voltage, such as +20 V is applied to the row line $X_a$ and thereby the selecting transistor $Q_2$ of the specified memory cell $MC_a$ is turned to ON. At the same time, a positive high voltage is applied to the drain D of the transistor $Q_1$ and zero voltage is applied to the control gate CG. Thus, the electron charges are removed from the floating gate FG and the logic "1" is written in the memory cell $MC_a$. In the memory of Figure 3, half-selected memory cells, such as $MC_b$, $MC_c$ and so on, and non-selected memory cells, such as $MC_d$ and so on, exist at the same time, other than selected memory cell $MC_a$. A half-selected memory cell is a cell for which the corresponding column line Y is selected, but, the corresponding row line X is not selected, or, alternately, the corresponding row line X is selected, but, the corresponding column line Y is not selected. When both the column and row lines are not selected, the corresponding cell is said to be non-selected. In this case, an undesired write operation cannot be expected, because no positive high voltage is applied to any drain D of the transistor $Q_1$ in each of the memory cells $MC_b$, $MC_c$ and $MC_d$ - - -. It should be noted that the write operation is performed when zero volt is applied to the control gate CG and at the same time the positive high voltage is applied to the drain D.

While, when a whole-erase operation is required with respect to the memory of Figure 3, firstly, zero volt is applied to all the column lines (Y), secondly, a positive high voltage $V_H$ is applied to all the word lines (X), and thirdly, the positive high voltage $V_H$ is applied to all the control gates CG, which three conditions are satisfied simultaneously. Thus, the electron charges are injected from the drain D into the floating gate FG in each of the transistors $Q_1$. It should be noted that the write operation is performed when zero volt is applied to the control gate CG and at the same time a positive high voltage is applied to the drain D.

In the above-mentioned write and whole-erase operations, no problem occurs. However, an undesired erasure may occur when a partial-erase operation is achieved, such as an erase operation with respect to memory cells forming a word of 8 bits. If some word is accessed in the memory, only a plurality of memory cells (MCs) for composing that accessed word must satisfy the aforementioned three conditions, that is, firstly, zero volt is applied to the column lines (Y), secondly, the positive high voltage $V_H$ is applied to the word line (X), and thirdly, the positive high voltage $V_H$ is applied to the control gates CG. Thus, electron charges are injected from each drain D into the corresponding each floating gate FG in the selected memory cells of that word.

However, the above-mentioned problem may often occur in the half-selected memory cells, especially the half-selected memory cells defined by the row line $X_a$ and the column lines other than the column line $Y_a$, i.e. the memory cells other than $MC_a$ arranged along the row line $X_a$ shown in Figure 3. In such half-selected memory cells, not only the word line $X_a$ but also the program line $PR_a$ are selected. Therefore, the corresponding transistors $Q_2$ of the half-selected memory cells are turned ON. Although these transistors $Q_2$ are ON, since the corresponding column lines, except for the line $Y_a$, are left in a floating state, the drains D of the transistors $Q_1$ of the half-selected memory cells are also left in a floating state through the respective transistors $Q_2$ which are now conductive. In this case, although a positive high voltage is applied to the respective control gates CG of the half-selected memory cells, the voltage level of the corresponding drains D are expected to increase toward a high voltage level via a so-called capacitor

3

coupling between each gate FG and each corresponding drain D. Therefore, it is also expected that no high electric field is created between each floating gate FG and each corresponding drain D and, as a result, that no undesired erase operation is achieved in each half-selected memory cell.

However, during actual operation, the previously mentioned problem occurs, that is, undesired erase operation is achieved in such half-selected memory cells for the following reasons. When a positive high voltage is applied to the control gate CG, the voltage level of the floating gate FG is also increased due to the capacitor coupling therebetween. In this case, a channel between the drain D and the source becomes conductive, because of the positive high voltage. When the channel is conductive, the drain D is not left in the aforesaid floating state but is changed to the same voltage level as that of the source S, which level is 0 V. Consequently, a condition, which is identical to the condition for achieving the erase operation, is satisfied, and thereby undesired erasing occurs in some of the half-selected memory cells, where the electron charges are injected from each drain D to each corresponding floating gate FG.

The above-mentioned undesired erasing may be prevented by employing an additional transistor which acts to disconnect the source S from the ground GND, selectively. However, this solution is not perfect in preventing all the undesired erasing. The important matter is to pay attention to the existence of a parasitic capacitor formed between the drain D and the substrate SUB (refer to the parasitic capacitor PC shown in Figure 2). To make the matter worse, the capacitance value of the capacitor PC is considerably large. In addition, the capacitance value of the capacitor PC may further be increased, because a parasitic capacitor, formed between the substrate SUB and the source S, is also added to the parasitic capacitor PC of the drain D. Since the drain D is provided with a large parasitic capacitor, the voltage level at the drain D cannot change at high speed. Accordingly, the voltage level at the drain D cannot increase at high speed when the positive high voltage $V_H$ is applied to the control gate CG. In other words, although the voltage level at the gate CG and also the gate FG changes sharply, the voltage level at the drain D cannot change so sharply. Therefore, a condition, corresponding to the erase operation, is unnecessarily satisfied in a moment during the term in which the voltage level at the drain D follows toward the positive high voltage level at the gate CG and saturates the corresponding positive high voltage level. Although such undesired erasing occurs in a very short time, if such undesired erasing occurs many times repeatedly, the stored data will completely be erased from the floating gate FG, which is one of the previously mentioned defects of the prior art.

Regarding one memory, in which a row line X and the corresponding program line PR are activated simultaneously, the control gates CG of the non-selected and half-selected memory cells, especially the half-selected memory cells having non-selected row lines X and selected column lines Y, are not selected (activated), and accordingly no electron charges are injected from the drains D to the respective floating gates FG. As a result, in such memory, above-mentioned undesired erasing cannot be expected to occur. Contrary to the above, regarding another memory in which all the control gates are selected (activated) to be a positive high voltage $V_H$, similar defects will be produced with respect to the half-selected memory cells having selected row lines X and non-selected column lines Y.

There may be a possibility to eliminate the occurrence of such an undesired erase operation by applying the positive high voltage $V_H$ not only to the control gate CG but also to the column line Y being connected to the drain D of the programming transistor $Q_1$. However, such possibility is not realized, because a complicated decoder circuit should be incorporated into the memory circuit. It should be noted that the simple decoder circuit of the prior art is sufficient merely to operate to supply high voltage to the column line Y during the erase operation and to make the column line Y to be in a floating state.

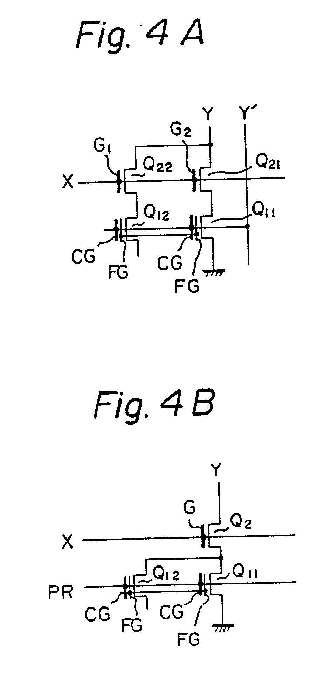

Figure 4A depicts an equivalent circuit diagram of each memory cell MC according to the present invention, while, Figure 4B depicts an equivalent circuit diagram of a prior art memory cell MC such as disclosed in US 4,208,158. Although each programming transistor $Q_1$ of Figures 2 and 3 is depicted as a single transistor element, in its actual arrangement each of the transistors $Q_1$ is divided into a first transistor $Q_{11}$, acting as a read transistor, having the thick insulation layer IS'' and a second transistor $Q_{12}$, acting as a write-erase transistor, having a partially thin insulation layer IS'.

One essential point of the present invention resides in that, as seen from Figure 4A, the selecting transistor $Q_2$ of Figure 2 or 3 is also divided into a first selecting transistor $Q_{21}$ which is connected in series with the read transistor $Q_{11}$, as usual, and a second selecting transistor $Q_{22}$ which is connected in series with the write-erase transistor $Q_{12}$.

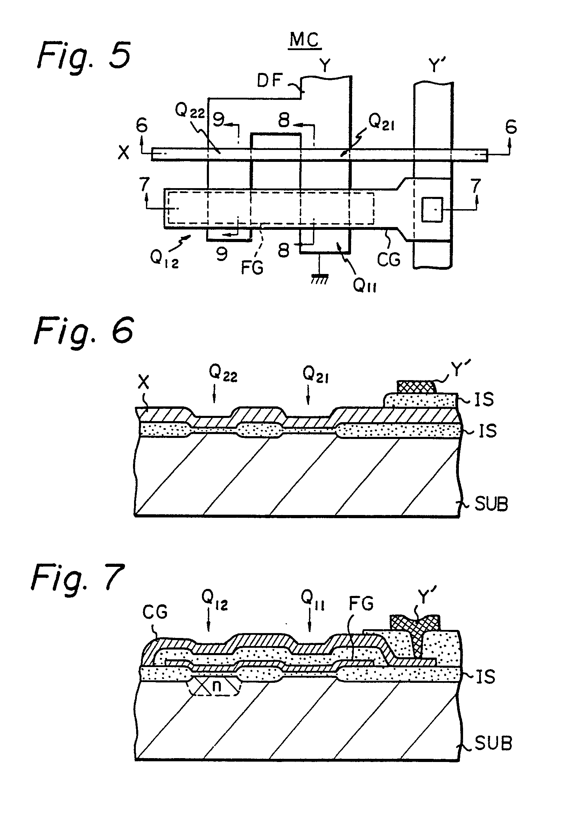

Figure 5 illustrates a plan view of a memory cell having the circuit diagram of Figure 4A, according to the present invention. In Figures 4A and 5, the members having the same reference symbols are identical. The reference symbol DF denotes a diffusion area. The construction of the memory cell MC shown in Figure 5 will be clarified with reference to Figures 6, 7, 8 and 9. Which are cross-sectional view of the memory cell shown in Figure 5 taken along the line 6—6, 7—7, 8—8 and 9—9 respectively.

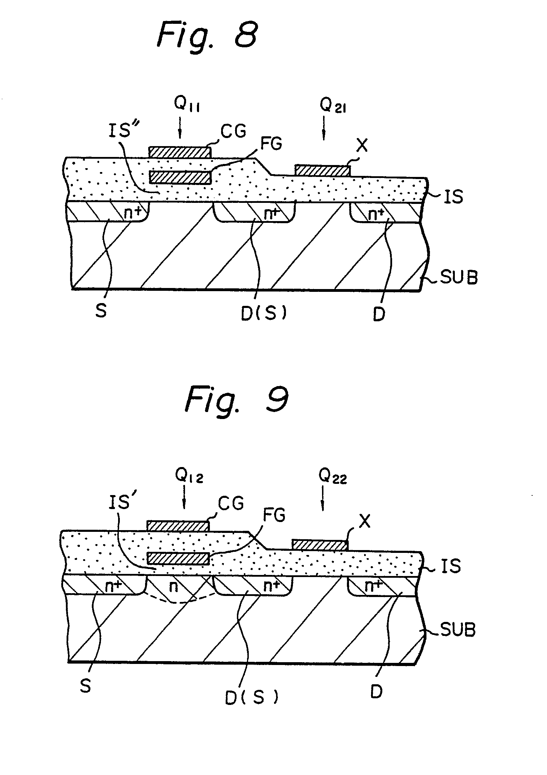

In Figure 5, as previously mentioned with reference to Figure 4A, the programming transistor $Q_1$ of Figure 3 is divided into the read transistor $Q_{11}$ and the write-erase transistor $Q_{12}$. The selecting transistor $Q_2$ of Figure 3 is also divided into the first selecting transistor $Q_{21}$ and the second selecting transistor $Q_{22}$. The diffusion area DF contains $n^+$-type impurities therein (see Figures 8 and 9). The diffusion area DF is electrically connected to the column line Y (see Figure 5). The diffusion area DF is formed to be a U-shaped area, as seen from Figure 5. The two gates X and CG traverse across and over the diffusion area DF so as to form four transistors $Q_{11} \sim Q_{22}$ at respective cross portions. Under the gates CG, FG and the row line X,

4

**0 053 075**

channels are created at respective transistors $Q_{11} \sim Q_{22}$. Especially, in the channel of the transistor $Q_{12}$, an n-type depletion region is formed. The drain D of the transistor $Q_{12}$ is shorted with the source S of the transistor $Q_{22}$, as seen from the area D(S) of Figure 9. The floating gate FG of the transistor $Q_{12}$ is provided with a relatively thin insulation layer IS' thereunder, but, other floating gates are provided with the relatively thick insulation layer IS'', as seen from Figures 8 and 9. This insulation layer IS' is thin enough to create the tunnel effect. Regarding the transistor $Q_{11}$, the impurity density of the substrate, located under the floating gate FG, may not be the same as that of the drain D thereof, alternately, that impurity density may be a value which enables creation of a full depletion state of this transistor, even though electron charges are fully injected into that gate FG.

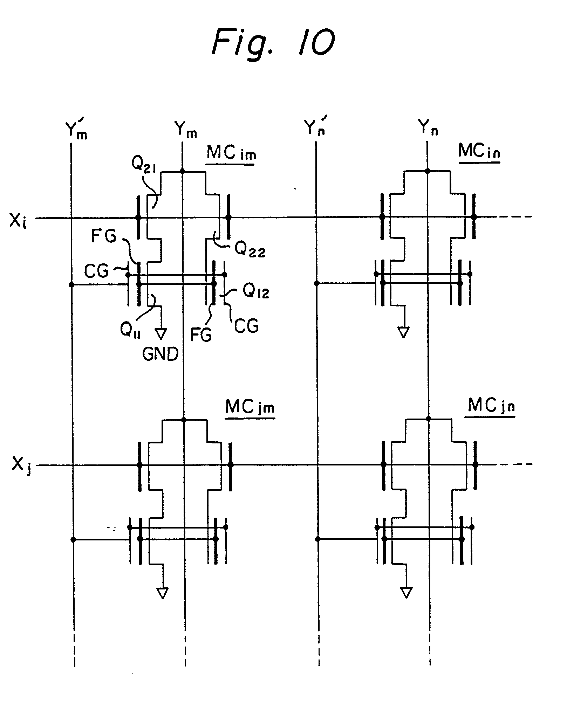

Although, in Figure 2, the program line PR is arranged in parallel with the row line X, the program line is distributed perpendicular to the row line X and at the same time in parallel with the column line Y, as the program line Y', which may be clarified with reference to Figures 4A and 5. The program line Y' is commonly connected to the control gate CG of each memory cells MC which cells are arranged in parallel with the column line Y. Any desired one of the program line Y' too can be selected by means of a usual decoder circuit which selects any desired one of the column lines (Y). The write and erase operations will be clarified with reference to Figure 10. Figure 10 illustrates a memory circuit diagram comprised of many memory cells according to the present invention such as shown in Figures 5 through 9. In Figure 10, only two column lines are illustrated as $Y_m$ and $Y_n$, only two row lines are illustrated as $X_i$ and $X_j$, only two program lines are illustrated as $Y'_m$ and $Y'_n$ and only four memory cells are illustrated as $MC_{im}$, $MC_{in}$, $MC_{jm}$ and $MC_{jn}$. Further it should be understood that, in each memory cell (MC), the locations of the transistors $(Q_{22}, Q_{12})$ and $(Q_{21}, Q_{11})$ are reversed with respect to the locations thereof shown in Figure 5, so as to simplify the illustration of the wiring diagram of Figure 10. When the write operation is commenced in the selected one, for example $MC_{im}$, of the memory cells, a positive high voltage is applied to the column line $Y_m$ ($Y_m=V_H$), zero voltage is applied to the program line $Y'_m$ ($Y'_m=0$) and a positive high voltage is applied to the row line $X_i$ ($X_i=V_H$). Accordingly, the first and second selecting transistors $Q_{21}$ and $Q_{22}$ are turned to ON and at the same time the positive high voltage is applied to each drain D of the read and write-erase transistor $Q_{11}$ and $Q_{12}$. In this case, since zero voltage is applied to the control gate CG, the electron charges are removed from the floating gate FG of the transistor $Q_{12}$ to the drain D thereof. Thus, the write operation is completed. In the above, mentioned case, regarding the non-selected memory cell $MC_{jn}$ and the half-selected memory cells $MC_{in}$ and $MC_{jm}$, since no positive high voltage $V_H$ is applied to any drains of the corresponding transistors $Q_{11}$ and $Q_{12}$, an undesired write operation for these non-selected and half-selected memory cells cannot be expected to occur.

When the whole-erase operation is commenced, zero voltage is applied to all the column lines ($Y_m$, $Y_n$ - - -), the positive high voltage $V_H$ is applied to all the row lines ($X_i$, $X_j$ - - -) and the positive high voltage $V_H$ is applied to all the program lines ($Y'_m$, $Y'_n$ - - -) and thereby electron charges are injected from the drain D of each transistor $Q_{12}$ to the floating gate FG thereof. Thus, the whole-erase operation is completed.

When the partial-erase operation is commenced, a similar condition as for the above whole-erase operation is satisfied with respect only to the selected memory cell, for example $MC_{im}$. That is, zero voltage is applied to the column line $Y_m$, the positive high voltage $V_H$ is applied to the program line $Y'_m$ and the positive high voltage $V_H$ is applied to the row line $X_i$. In this case, regarding the half-selected memory cell $MC_{in}$ having the selected row line $X_i$ and the non-selected column line $Y_n$, no undesired partial-erase operation is performed in such half-selected memory cell $MC_{in}$, as in any other similarly half-selected memory cells. This is because, firstly, the corresponding program lines $Y'_n$ and so on are not selected, and accordingly the corresponding control gates CG are left in an open state or zero voltage state, in which no undesired erase operation can be expected to occur. Secondly, in the other half-selected memory cells, such as $MC_{jm}$ having the non-selected row line $X'_j$, and the selected column line $Y_m$, the control gates CG cells receive the positive high voltage $V_H$; however, the write-erase transistors $Q_{12}$ are left in floating state, and accordingly no undesired erase operation can be performed. Thirdly, in the memory cells, the write-erase transistor $Q_{12}$ is fabricated in a small size, and therefore, the parasitic capacitor (refer to PC in Figure 2) formed between the drain D of the transistor $Q_{12}$ and the substrate can also be very small in area. Consequently, the voltage level developed at the drain D of the write-erase transistor $Q_{12}$ can quickly follow the change of the voltage level developed at the control gate CG. As previously mentioned, since the parasitic capacitor PC of the prior art is considerably large, undesired erase operation is often performed. Thus, no injection of the electron charges into the floating gate FG is expected in the half-selected memory cells. Further, no injection of the electron charges into the floating gate FG is expected in the non-selected memory cells.

In Figure 10, when the read operation is achieved, the positive voltage is applied to both the row and column lines X, Y of the selected memory cell MC. If the selected memory cell MC stores the logic "1" (no electron charges are held at the floating gate FG thereof), the voltage level of the floating gate is positive, and therefore the threshold level of the selected transistor $Q_{11}$ is reduced. Thus, the transistor $Q_{11}$ is left in the normal—ON state. In this case, current flows from the column line Y to the ground GND via the transistors $Q_{21}$ and $Q_{11}$, which are now ON.

Contrary to the above, if the selected memory cell MC stores the logic "0" (electron charges are held at the floating gate FG thereof), the voltage level of the floating gate FG is negative, and therefore the threshold level of the selected transistor $Q_{11}$ is increased. Thus, the transistor $Q_{11}$ is left in normal—OFF state. In this case, no current flows from the column line Y to the ground GND via the transistors $Q_{21}$ and $Q_{11}$.

As mentioned above, the stored data "1" or "0" is read from each memory cell. In this case, the voltage level at the control gate CG is not restricted to the above-mentioned zero voltage, but may be a suitable positive voltage level which is predetermined, for an erase operation and a write operation, according to the respective threshold levels of the memory cells.

The following table I shows the voltage level to be supplied at the row line X, the program line Y' and the column line Y, in each of the read (READ), the write (WRITE), the partial-erase (PARTIAL ERASE) and the whole-erase (WHOLE ERASE) operations, with respect to the selected memory cell $MC_s$, the half-selected memory cell $MC_{HSX}$ having the selected row line X only, the half-selected memory cell $MC_{HSY}$ having the selected column line Y only and the non-selected memory cell $MC_{non}$.

TABLE I

| | | $MC_S$ | $MC_{HSX}$ | $MC_{HSY}$ | $MC_{non}$ |
|---|---|---|---|---|---|
| READ | X | $V_4 \sim V_{CC}$ | $V_4$ | 0 | 0 |
| | Y' | $V_2$ | $V_2$ or 0 | $V_2$ or 0 | $V_2$ or 0 |
| | Y | $V_3$ | 0 | $V_3$ | 0 |
| WRITE | X | $V_1$ | $V_1$ | 0 | 0 |
| | Y' | 0 | 0 | 0 | 0 |
| | Y | $V_1$ | 0 | $V_1$ | 0 |
| PARTIAL ERASE | X | $V_1$ | $V_1$ | 0 | 0 |
| | Y' | $V_1$ | 0 | $V_1$ | 0 |
| | Y | 0 | 0 | 0 | 0 |
| WHOLE ERASE | X | $V_1$ | | | |
| | Y' | $V_1$ (all bits) | | | |
| | Y | 0 | | | |

In the above cited Table I, the reference symbol $V_1$ denotes the positive high voltage higher than the ordinary power supply voltage level of $V_{CC}$; the reference symbol $V_2$ denotes a read voltage level at the line Y'; $V_3$ a read voltage level at the line Y; and, $V_4$ a suitable read voltage level at the row line X.

As can be understood from Figures 5 through 9, the memory circuit device of the present invention is suitable for mass-production. This is because, if a slight error occurs in the location, with respect to the diffusion area DF, of the row line X, the control gate CG or the floating gate FG, in the vertical and/or horizontal directions in the drawing of Figure 5, such a locational error does not cause a significant defect in the manufactured memory cells, due to the presence of the U-shaped diffusion area DF.

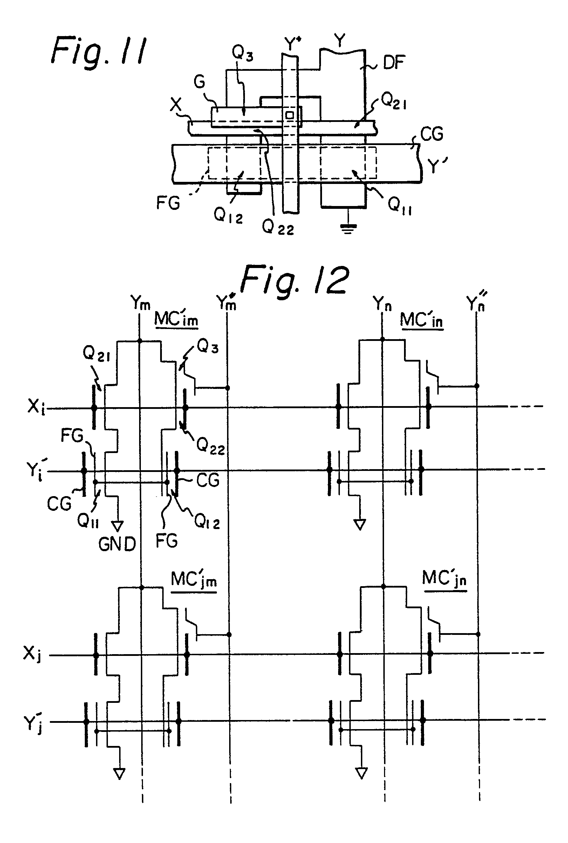

Figure 11 illustrates a plan view showing another embodiment of the memory cell according to the present invention. This figure corresponds to Figure 5 showing the first embodiment according to the present invention. In Figures 5 and 11, members referenced by the same reference symbols are substantially the same. The memory cell of Figure 11 differs from that of Figure 5 essentially by the provision of a third selecting transistor $Q_3$ and an additional program line Y'' are newly introduced therein. The third selecting transistor $Q_3$ cooperates with the second selecting transistor $Q_{22}$. In this case, the previously mentioned program line PR (Figure 2) is composed of the first program line Y' and the second program line Y''. The second program line Y'' is coupled to the gate G of the third selecting transistor $Q_3$. The channel of the transistor $Q_3$ is also formed inside the U-shaped diffusion area DF. The first program line Y' is arranged in parallel with the row line X. The second program line Y'' is arranged in parallel with the column line Y. The line Y'' is selected by means of the decoder circuit, usually used for selecting a desired one of the column lines Y.

Figure 12 illustrates a memory circuit diagram comprised of many memory cells according to said another embodiment of the present invention. However, only two column lines are illustrated as $Y_m$ and $Y_n$, only two row lines are illustrated as $X_i$ and $X_j$, only two first program lines are illustrated as $Y'_i$ and $Y'_j$, only two second program lines are illustrated as $Y''_m$ and $Y''_n$, and only four memory cells are illustrated as $MC'_{im}$, $MC'_{in}$, $MC'_{jm}$ and $MC'_{jn}$. Further it should be understood that, in each memory cells (MC), the locations of the transistors ($Q_{22}$, $Q_{12}$, $Q_3$) and ($Q_{21}$, $Q_{11}$) are reversed with respect to the locations thereof shown in Figure 11, so as to simplify the illustration of the wiring diagram.

In Figure 12, when the column line $Y_m$ is selected, the corresponding line $Y''_m$ is also selected, and similarly when the column line $Y_n$ is selected, the corresponding line $Y''_n$ is selected.

When the write operation is commenced, in a selected one, for example $MC'_{im}$, of the memory cells, a

6

# 0 053 075

positive high voltage is applied to the column line $Y_m$ ($Y_m = V_H$), positive high voltage is applied to the second program line $Y''_m$ ($Y''_m = V_H$) and a positive high voltage is applied to the row line $X_i$ ($X_i = V_H$). Accordingly, the first, second and third selecting transistors $Q_{21}$, $Q_{22}$ and $Q_3$ are turned to ON and at the same time the positive high voltage is applied to each drain D of the read and write-erase transistors $Q_{11}$ and $Q_{12}$. In this case, since zero voltage is applied to the control gate CG, the electron charges are removed from the floating gate FG of the transistor $Q_{12}$ to the drain D thereof. Thus, the write operation is completed. In the above case, regarding the non-selected memory cell such as $MC'_{jn}$ and the half-selected memory cells such as $MC'_{in}$ and $MC'_{jm}$, since firstly no positive high voltage $V_H$ is applied to the drain of the corresponding transistor $Q_{12}$ and secondly the corresponding transistors $Q_{22}$ and $Q_3$ are OFF, an undesired write operation for these non-selected and half-selected memory cells cannot be expected to occur.

When the whole-erase operation is commenced, zero voltage is applied to all the column lines ($Y_m$, $Y_n$ . . .), the positive high voltage $V_H$ is applied to all the row lines ($X_i$, $X_j$ . . .), the positive high voltage $V_H$ is applied to all the first program lines ($Y'_i$, $Y'_j$ . . .) and the voltage $V_H$ is applied to all the second program lines ($Y''_m$, $Y''_n$ . . .), and thereby electron charges are injected from the drain D of each transistor $Q_{12}$ to the floating gate FG thereof. Thus, the whole-erase operation is completed.

When a partial-erase operation is commenced, a condition similar to the one of the above whole-erase operation is satisfied with respect only to the selected memory cell, for example $MC'_{im}$. In this case, regarding the half-selected memory cell $MC'_{in}$ having the selected row line $X_i$ and the non-selected column line $Y_n$, the second program line $Y''_n$ is also non-selected, and accordingly the transistor $Q_3$ is turned to OFF, and the transistor $Q_{12}$ of the cell $MC'_{in}$ is in a floating state. Consequently, the voltage level of the drain D of this transistor $Q_{12}$ changes together with the voltage level of the control gate CG and also the floating gate FG of the transistor $Q_{12}$ in the cell $MC'_{in}$. Thereby, no undesired erase operation can be expected to occur in the half-selected memory cell $MC'_{in}$.

Regarding the half-selected memory cell $MC'_{jm}$ having the non-selected row line $X_j$ and the selected column line $Y_m$, since the first program line $Y'_j$ is not selected, there is no possibility that electron charges be injected into the floating gate FG of the cell $MC'_{jm}$. Regarding the non-selected memory cell $MC'_{jn}$, since the lines $X_j$, $Y_n$, $Y''_n$ and $Y'_j$ are not selected, there is also no possibility that electron charges be injected into the floating gate FG of the cell $MC'_{jn}$. This is why no desired erase operation is achieved in any of the memory cells other than the selected memory cell.

The read operation of the memory shown in Figure 12 is substantially the same as that of Figure 10. In this case, the first program lines $Y'_i$, $Y'_j$ . . . of Figure 12 should be supposed to be the program lines $Y'_m$, $Y'_n$ . . . of Figure 10. The second program line $Y''_m$, $Y''_n$ . . . of Figure 12 can be in free states during the read operation, that is the voltage level of these lines $Y''_m$, $Y''_n$ may be a high voltage or a low voltage level. Thus, operations of the memory shown in Figure 12 are classified as represented by the following Table II. Table II corresponds to the previously cited Table I.

## Claims

1. A nonvolatile memory comprising a plurality of memory cells ($MC$, . . ., $MC_{im}$, . . .; $MC'_{im}$, . . .) and a plurality of column lines ($Y$, . . ., $Y_m$, . . .) row lines ($X$, . . ., $X_i$, . . .) and program lines ($Y'$, . . ., $Y'_m$, . . .; $Y''_m$, . . .) which cooperate with the memory cells, each memory cell comprising a selecting transistor ($Q_{21}$, $Q_{22}$) and a programming transistor connected in series with the selecting transistor and comprised of a read transistor ($Q_{11}$) having a control gate (CG) and a floating gate (FG) provided with a relatively thick insulation layer thereunder, and a write-erase transistor ($Q_{12}$) having a control gate (CG) and a floating gate (FG) provided with, partially, a relatively thin insulation layer thereunder, the control gates being commonly connected and the floating gates being also commonly connected, the selecting transistor having a drain connected to the column line and a gate connected to the row line, and the read and write-erase transistors having their control gates connected to the program lines, characterized in that, in each of the memory cells, the selecting transistor is divided into a first selecting transistor ($Q_{21}$) and a second selecting transistor ($Q_{22}$), the first selecting transistor ($Q_{21}$) being serially connected with the read transistor ($Q_{11}$) and the second selecting transistor ($Q_{22}$) being serially connected with the write-erase transistor ($Q_{12}$), and in that the program lines ($Y'$, . . ., $Y'_m$, . . .; $Y''_m$, . . .) are arranged substantially in parallel with the column lines ($Y$, . . ., $Y_m$, . . .) in the form of lines intersecting the row lines ($X$, . . ., $X_i$, . . .).

2. A nonvolatile memory as set forth in claim 1, wherein said first and second selecting transistors ($Q_{21}$, $Q_{22}$) and said read and write-erase transistors ($Q_{11}$, $Q_{12}$) are formed in and on a semiconductor substrate (SUB) having a U-shaped diffusion area (DF) therein, electrically connected to said column line (Y), so as to form drains and sources of the above four transistors, both said first selecting transistor ($Q_{21}$) and said read transistor ($Q_{11}$) being formed on and along one side of said U-shaped area and both said second selecting transistor ($Q_{22}$) and said write-erase transistor ($Q_{21}$) being formed on and along the other side thereof.

3. A nonvolatile memory as set forth in claim 2, wherein both said first and second selecting transistors ($Q_{21}$, $Q_{22}$) are located close to the bottom side of said U-shaped diffusion area (DF) and both said read and write-erase transistors ($Q_{11}$, $Q_{12}$) are located close to the upper open ends of said U-shaped diffusion area (DF).

4. A nonvolatile memory as set forth in claim 3, wherein the gates of said first and second selecting transistors ($Q_{21}$, $Q_{22}$) connect, at respective cross portions, with a row line (X) which is arranged

7

perpendicular to said column line (Y), both the control gates of said write-erase transistor and said read transistor ($Q_{12}$, $Q_{11}$) connect at respective cross portions, with a sub-part of said program line.

5. A nonvolatile memory as set forth in claim 4, wherein said diffusion area (DF) comprising the drains and sources of said four transistors has an $n^+$-type conductivity.

6. A nonvolatile memory as set forth in claim 5, wherein a channel formed between the drain and source of said write-erase transistor ($Q_{12}$) has n-type conductivity.

7. A nonvolatile memory as set forth in claim 1, wherein in each of said memory cells, a first program line and a second program line are provided, said first and second selecting transistors ($Q_{21}$, $Q_{22}$) being further provided with a third selecting transistor ($Q_3$) cooperating with the second selecting transistor ($Q_{22}$) as one body, the control gates of the read and write-erase transistors ($Q_{11}$, $Q_{12}$) are coupled with the first program line ($Y'$, . . ., $Y'_i$, . . .) and the second program line ($Y''$, . . ., $Y''_m$, . . .) is coupled with the gate of the third selecting transistor ($Q_3$) and is activated only when the corresponding memory cell is selected.

8. A nonvolatile memory as set forth in claim 7, wherein said first, second and third selecting transistors ($Q_{21}$, $Q_{22}$, $Q_3$) and said read and write-erase transistors ($Q_{11}$, $Q_{12}$) are formed in and on a semiconductor substrate, the semiconductor substrate contains a U-shaped diffusion area (DF) therein, electrically connected to said column line, so as to form drains and sources of the above five transistors, both said first selecting transistor ($Q_{21}$) and said read transistor ($Q_{11}$) being formed on and along one side of said U-shaped area and said second and third selecting transistors ($Q_{22}$, $Q_3$) and said write-erase transistor ($Q_{12}$) being formed on and along the other side thereof.

9. A nonvolatile memory as set forth in claim 8, wherein said first, second and third selecting transistors ($Q_{21}$, $Q_{22}$, $Q_3$) are located close to the bottom side of said U-shaped diffusion area (DF) and both said read and write-erase transistors ($Q_{11}$, $Q_{12}$) are located close to the upper open ends thereof.

10. A nonvolatile memory as set forth in claim 9, wherein both the gates of said first and second selecting transistors ($Q_{21}$, $Q_{22}$) connect, at respective cross portions, with a row line (X, . . .) which is arranged perpendicular to said column line (Y, . . .), both the control gates of said write-erase transistor ($Q_{12}$) and said read transistor ($Q_{11}$) connect at respective cross portions, with said first program line ($Y'$, . . .) which is arranged in parallel with said row line, the second program line ($Y''$, . . .) being arranged perpendicular to both said row line (X, . . .) and first program line ($Y'$, . . .).

11. A nonvolatile memory as set forth in claim 10, wherein said second program line ($Y''$, . . .) is arranged in parallel with and inside both sides of said U-shaped diffusion area (DF).

## Patentansprüche

1. Nichtflüchtiger Speicher mit einer Vielzahl von Speicherzellen (MC, . . ., $MC_{im}$, . . .; $MC'_{im}$, . . .) und einer Vielzahl von Spaltenleitungen (Y, . . ., $Y_m$, . . .), Reihenleitungen (X, . . ., $X_i$, . . .) und Programmleitungen ($Y'$, . . ., $Y'_m$, . . .; $Y''_m$, . . .), die mit den Speicherzellen zusammenarbeiten, wobei jede Speicherzelle einen auswählenden Transistor ($Q_{21}$, $Q_{22}$) und einen programmierenden Transistor umfaßt, der in Reihe mit dem auswählenden Transistor angeschlossen ist und aus einem Lesetransistor ($Q_{11}$), der ein Steuergate (CG) und ein schwimmendes Gate (FG) hat, das mit einer relativ dicken Isolationsschicht darunter versehen ist, und einem Schreib-Lösch-Transistor ($Q_{12}$) besteht, der ein Steuergate (CG) und ein schwimmendes Gate (FG) hat, das, teilweise, mit einer relativ dünnen Isolationsschicht darunter versehen ist, wobei die Steuergates gemeinsam angeschlossen sind und die schwimmenden Gates ebenfalls gemeinsam angeschlossen sind, der auswählende Transistor ein Drain hat, das mit der Spaltenleitung verbunden ist, und ein Gate, das mit der Reihenleitung verbunden ist, und die Lese- und Schreib-Lösch-Transistoren ihre gemeinsamen Steuergates mit den Programmleitungen verbunden haben, dadurch gekennzeichnet, daß in jeder der Speicherzellen der auswählende Transistor geteilt ist in einen ersten auswählende Transistor ($Q_{21}$) und einen zweiten auswählenden Transistor ($Q_{22}$), der erste auswählende Transistor ($Q_{21}$) seriell mit dem Lesetransistor ($Q_{11}$) verbunden ist und der zweite auswählende Transistor ($Q_{22}$) seriell mit dem Schreib-Lösch-Transistor ($Q_{12}$) verbunden ist und daß die Programmleitungen ($Y'$, . . ., $Y'_m$, . . ., $Y''_m$, . . .) im wesentlichen parallel zu den Spaltenleitungen (Y, . . ., $Y_m$, . . .) in Form von Leitungen, welche die Reihenleitungen (X, . . ., $X_i$, . . .) schneiden, angeordnet sind.

2. Nichtflüchtiger Speicher nach Anspruch 1, bei dem die genannten ersten und zweiten auswählenden Transistoren ($Q_{21}$, $Q_{22}$) und die genannten Lese- und Schreib-Lösch-Transistoren ($Q_{11}$, $Q_{12}$) in und auf einem Halbleitersubstrat (SUB) gebildet sind, das einen U-förmigen Diffusionsbereich (DF) darin enthält, der elektrisch mit der genannten Spaltenleitung (Y) verbunden ist, um so Drains und Sourcen der obigen vier Transistoren zu bilden, beide, der genannte erste auswählende Transistor ($Q_{21}$) und der genannte Lesetransistor ($Q_{11}$) auf und längs einer Seite des genannten U-förmigen Bereiches gebildet sind und beide, der genannte zweite auswählende Transistor ($Q_{22}$) und der genannte Schreib-Lösch-Transistor ($Q_{21}$), auf und längs der anderen Seite davon gebildet sind.

3. Nichtflüchtiger Speicher nach Anspruch 2, bei dem beide, der genannte erste und der genannte zweite auswählende Transistor ($Q_{21}$, $Q_{22}$), nahe der Bodenseite des genannten U-förmigen Diffusionsbereiches (DF) angeordnet sind und beide, der genannten Lese- und der Schreib-Lösch-Transistor ($Q_{11}$, $Q_{12}$), nahe den oberen offenen Enden des genannten U-förmigen Diffusionsbereiches (DF) angeordnet sind.

4. Nichtflüchtiger Speicher nach Anspruch 3, bei dem die Gates der genannten ersten und zweiten

auswählenden Transistoren ($Q_{21}$, $Q_{22}$), an entsprechenden Kreuzungsabschnitten, mit einer Reihenleitung (X) verbunden sind, die senkrecht zu der Spaltenleitung (Y) angeordnet ist, beide, die Steuergates des genannten Schreib-Lösch-Transistors und des genannten Lesetransistors ($Q_{12}$, $Q_{11}$), an entsprechenden Kreuzungsabschnitten mit einem Unterabschnitt der genannten Programmleitung verbunden sind.

5. Nichtflüchtiger Speicher nach Anspruch 4, bei dem der genannte Diffusionsbereich (DF), der die Drains und Sourcen der genannten vier Transistoren umfaßt, eine $n^{+}$-Typ-Leitfähigkeit hat.

6. Nichtflüchtiger Speicher nach Anspruch 5, bei dem ein Kanal, der zwischen Drain und Source des genannten Schreib-Lösch-Transistors ($Q_{12}$) gebildet ist, eine n-Typ-Leitfähigkeit hat.

7. Nichtflüchtiger Speicher nach Anspruch 1, bei dem in jeder der genannten Speicherzellen eine erste Programmleitung und eine zweite Programmleitung vorgesehen sind, die genannten ersten und zweiten auswählenden Transistoren ($Q_{21}$, $Q_{22}$) ferner mit einem dritten auswählenden Transistor ($Q_3$) versehen sind, der mit dem zweiten auswählenden Transistor ($Q_{22}$) als ein Körper zusammenarbeitet, die Steuergates der Lese- und Schreib-Lösch-Transistoren ($Q_{11}$, $Q_{12}$) mit der ersten Programmleitung ($Y'$, . . ., $Y''_{I}$, . . .) verbunden sind und die zweite Programmleitung ($Y''$, . . . $Y''_{m}$, . . .) mit dem Gate des dritten auswählenden Transistors ($Q_3$) verbunden ist und nur dann aktiviert wird, wenn die entsprechende Speicherzelle ausgewählt ist.

8. Nichtflüchtiger Speicher nach Anspruch 7, bei dem die genannten ersten und zweiten und dritten auswählenden Transistoren ($Q_{21}$, $Q_{22}$, $Q_3$) und die genannten Lese- und Schreib-Lösch-Transistoren ($Q_{11}$, $Q_{12}$) in und auf einem Halbleitersubstrat gebildet sind, welches Halbleitersubstrat einen U-förmigen Diffusionsbereich (DF) darin enthält, elektrisch mit der genannten Spaltenleitung verbunden sind, um so Drains und Sourcen der obigen fünf Transistoren zu bilden, beide, der genannte erste auswählende Transistor ($Q_{21}$) und der genannte Lesetransistor ($Q_{11}$) auf und längs einer Seite des U-förmigen Bereiches gebildet sind und der genannte zweite und dritte auswählende Transistor ($Q_{22}$, $Q_3$) und der genannte Schreib-Lösch-Transistor ($Q_{12}$) auf und längs der anderen Seite desselben gebildet sind.

9. Nichtflüchtiger Speicher nach Anspruch 8, bei dem die genannten ersten, zweiten und dritten auswählenden Transistoren ($Q_{21}$, $Q_{22}$, $Q_3$) nahe der Bodenseite des genannten U-förmigen Diffusionsbereiches (DF) angeordnet sind und beide, der genannte Lese- und der Schreib-Lösch-Transistor ($Q_{11}$, $Q_{12}$) nahe den oberen offenen Enden davon angeordnet sind.

10. Nichtflüchtiger Speicher nach Anspruch 9, bei dem beide, die Steuergates des genannten ersten und zweiten auswählenden Transistors ($Q_{21}$, $Q_{22}$) an entsprechenden Kreuzungsabschnitten mit einer Reihenleitung (X, . . .) verbunden sind, welche senkrecht zu der Spaltenleitung (Y, . . .) angeordnet sind, beide, die Steuergates des genannten Schreib-Lösch-Transistors ($Q_{12}$) und des genannten Lesetransistors ($Q_{11}$), an entsprechenden Kreuzabschnitten mit der genannten ersten Programmleitung ($Y'$, . . .) verbunden sind, die parallel zu den Reihenleitungen angeordnet ist, die zweite Programmleitung ($Y''$, . . .) senkrecht zu beiden, der genannten Reihenleitung (X, . . .) und der ersten Programmleitung ($Y'$, . . .) angeordnet ist.

11. Nichtflüchtiger Speicher nach Anspruch 10, bei dem die genannte zweite Programmleitung ($Y''$, . . .) parallel zu und innerhalb beider Seiten des U-förmigen Diffusionsbereiches (DF) angeordnet ist.


## Revendications

1. Mémoire permanente comprenant plusieurs cellules de mémoire (MC, . . ., $MC_{im}$, . . .; $MC'_{im}$, . . .) et plusieurs lignes de colonne (Y, . . ., $Y_m$, . . .), lignes de rangée (X, . . ., $X_I$, . . .) et lignes de programme ($Y'$, . . ., $Y'_n$, . . .; $Y''_m$, . . .) qui coopèrent avec les cellules de mémoire, chaque cellule de mémoire comprenant un transistor de sélection ($Q_{21}$, $Q_{22}$) et un transistor de programmation connectés en série avec le transistor de sélection est constituée par un transistor de lecture ($Q_{11}$) qui possède une grille de commande (CG) et une grille flottante (FG) comportant sous elles une couche d'isolation relativement épaisse, et d'un transistor d'écriture-effacement ($Q_{12}$) qui possède une grille de commande (CG) et une grille flottante (FG) comportant sous elles, partiellement, une couche d'isolation relativement mince, les grilles de commande étant connectées en commun et les grilles flottantes étant également connectées en commun, le transistor de sélection possédant un drain qui est connecté à la ligne de colonne et une grille qui est connectée à la ligne de rangée, et les transistors de lecture et d'écriture-effacement étant connectés par leurs lignes de commande aux lignes de programme, caractérisée en ce que, dans chacune des cellules de mémoire, le transistor de sélection se divise en un premier transistor de sélection ($Q_{21}$) et un deuxième transistor de sélection ($Q_{22}$), le premier transistor de sélection ($Q_{21}$) étant connecté en série avec le transistor de lecture ($Q_{11}$), et le deuxième transistor de sélection ($Q_{22}$) étant connecté en série avec le transistor d'écriture-effacement ($Q_{12}$), et en ce que les lignes de programme ($Y'$, . . ., $Y'_m$, . . .; $Y''_m$, . . .) sont disposées sensiblement parallèlement aux lignes de colonne (Y, . . ., $Y_m$, . . .) sous la forme de lignes coupant les lignes de rangée (X, . . ., $X_I$, . . .).

2. Mémoire permanente selon la revendication 1, où lesdits premier et deuxième transistors de sélection ($Q_{21}$, $Q_{22}$) et lesdits transistors de lecture et d'écriture-effacement ($Q_{11}$, $Q_{12}$) sont formés dans et sur un substrat semiconducteur (SUB) qui comporte une aire de diffusion (DF) en forme de U, électriquement connectée à ladite ligne de colonne (Y), de manière à former des drains et des sources pour les quatre transistors placés au-dessus, ledit premier transistor de sélection ($Q_{21}$) et ledit transistor de lecture ($Q_{11}$) étant tous deux formés sur un premier côté de ladite aire en forme de U et le long de celui-ci, et

# 0 053 075

ledit deuxième transistor de sélection ($Q_{22}$) et ledit transistor d'écriture-effacement ($Q_{21}$) étant tous deux formés sur l'autre côté de celle-ci et le long de cet autre côté.

3. Mémoire permanente selon la revendication 2, où lesdits premier et deuxième transistors de sélection ($Q_{21}$, $Q_{22}$) sont placés près du côté inférieur de ladite aire de diffusion (DF) en forme de U et lesdits transistors de lecture et d'écriture-effacement ($Q_{11}$, $Q_{12}$) étant tous deux placés près des extrémités ouvertes supérieures de l'aire de diffusion (DF) en forme de U.

4. Mémoire permanente selon la revendication 3, où les grilles desdits premier et deuxième transistor de sélection ($Q_{21}$, $Q_{22}$) se connectent, en des perties de croisement respectives, avec une ligne de rangée (X) qui est disposée perpendiculairement à ladite ligne de colonne (Y), les grilles de commande dudit transistor d'écriture-effacement et dudit transistor de lecture ($Q_{12}$, $Q_{11}$) se connectant toutes, deux, en des parties de croisement respectives, avec une sous-partie de ladite ligne de programme.

5. Mémoire permanente selon la revendication 4, où ladite aire de diffusion (DF) comprenant les drains et les sources desdits quatre transistors possède une conductivité de type $n^+$.

6. Mémoire permanente selon la revendication 5, où un canal formé entre le drain et la source dudit transistor écriture-effacement ($Q_{12}$) possède une conductivité de type n.

7. Mémoire permanente selon la revendication 1, où, dans chacune desdites cellules de mémoire, une première ligne de programme et une deuxième ligne de programme sont prévues, lesdits premier et deuxième transistors de sélection ($Q_{21}$, $Q_{22}$) étant en outre dotés d'un troisième transistor de sélection ($Q_3$) qui coopère avec la deuxième transistor de sélection ($Q_{22}$) d'une seule pièce, les grilles de commande des transistors de lecture et d'écriture-effacement ($Q_{11}$, $Q_{12}$) sont couplés avec la première ligne de programme ($Y'$, ..., $Y'_{l}$, ...) et la deuxième ligne de programme ($Y''$, ..., $Y''_{m}$, ...) est couplée avec la grille du troisième transistor de sélection ($Q_3$) et n'est activée que lorsque la cellule de mémoire correspondante a été sélectionnée.

8. Mémoire permanente selon la revendication 7, où lesdits premier, deuxième et troisième transistors de sélection ($Q_{21}$, $Q_{22}$, $Q_3$) et lesdits transistors de lecture et d'écriture-effacement ($Q_{11}$, $Q_{12}$) sont formés dans et sur un substrat semiconducteur, le substrat semiconducteur contient une aire de diffusion (DF) en forme de U, électriquement connectée à ladite ligne de colonne, de manière à former les drains et les sources des cinq transistors placés au-dessus, ledit premier transistor de sélection ($Q_{21}$) et ledit transistor de lecture ($Q_{11}$) étant tous deux formés sur un premier côté de ladite aire en forme de U et le long de celui-ci, et lesdits deuxième et troisième transistors de sélection ($Q_{22}$, $Q_3$) et ledit transistor d'écriture-effacement ($Q_{12}$) étant formé sur l'autre côté de celle-ci et le long de cet autre côté.

9. Mémoire permanente selon la revendication 8, où lesdits premier, deuxième et troisième transistors de sélection ($Q_{21}$, $Q_{22}$, $Q_3$) sont placés près du côté inférieur de l'aire de diffusion (DF) en forme de U et lesdits transistors de lecture et d'écriture-effacement ($Q_{11}$, $Q_{12}$) sont tous deux placés près de ces extrémités ouvertes supérieures.

10. Mémoire permanente selon la revendication 9, où les grilles desdits premier et deuxième transistors de sélection ($Q_{21}$, $Q_{22}$) se connectent toutes deux, en des parties de croisement respectives, avec une ligne de rangée (X, ...) qui est disposée perpendiculairement à ladite ligne de colonne (Y, ...), les grilles de commande dudit transistor d'écriture-effacement ($Q_{12}$) et dudit transistor de lecture ($Q_{11}$) se connectent toutes deux, en des parties de croisement respectives, avec ladite première ligne de programme ($Y'$, ...) qui est disposée parallèlement à ladite ligne de rangée, la deuxième ligne de programme ($Y''$, ...) étant disposée perpendiculairement à ladite ligne de rangée (X, ...) ainsi qu'à ladite première ligne de programme ($Y'$, ...).

11. Mémoire permanente selon la revendication 10, où ladite deuxième ligne de programme ($Y''$, ...) est disposée parallèlement aux deux côtés de ladite aire de diffusion (DF) en forme de U, à l'intérieur de celle-ci.

# Fig. 1

# Fig. 2

MC

# Fig. 3

# Fig. 4 A

# Fig. 4 B

*Fig. 5*

*Fig. 6*

*Fig. 7*

# Fig. 8

# Fig. 9

# Fig. 10

*Fig. 11*

*Fig. 12*